# EUROPÄISCHE PATENTSCHRIFT

(11) **EP 0 747 739 B1**
(45) Veröffentlichungstag und Bekanntmachung des Hinweises auf die Patenterteilung: **10.05.2006**
(21) Anmeldenummer: 96100723.4
(22) Anmeldetag: 19.01.1996
(51) Int. Cl.: G02B 6/124, G02B 5/18

(54) **Verfahren zur Ausnutzung scheibenförmigen Ausgangsmaterials bei der Herstellung optoelektronischer Bauelemente mit Gittern variabler Gitterperiode**
Method for using disc shaped material in the manufacture of optoelectronic components with variable grating period
Méthode d'utilisation d'un matériau en forme de disque pour la manufacture des composants opto-électroniques avec période variable du réseau

(30) Priorität: 30.05.1995 DE 19520819
(43) Veröffentlichungstag der Anmeldung: 11.12.1996
(73) Patentinhaber: ADC Telecommunications, Inc., Eden Prairie, MN 55344-2252 (US)
(72) Erfinder: Hillmer, Hartmut, Dr.rer.nat., D-64287 Darmstsdt (DE)
(74) Vertreter: Eisenführ, Speiser & Partner

(56) Entgegenhaltungen:
- EP-A- 0 647 867
- DE-A- 3 426 703
- JOURNAL OF OPTICAL COMMUNICATIONS, Bd. 14, Nr. 1, 1993, BERLIN DE, Seiten 18-24, XP000355257 H.J. BRÜCKNER ET AL.: "PERFORMANCE OF ELECTRON BEAM WRITTEN DIELECTRIC WAVEGUIDE GRATING FILTERS CONSIDERING FABRICATION TOLERANCES"
- MICROELECTRONIC ENGINEERING, Bd. 9, Nr. 1-4, Mai 1989, AMSTERDAM NL, Seiten 235-238, XP000034365 H. OHKI ET AL.: "FABRICATION OF GRATING PATTERNS BY E-BEAM LITHOGRAPHY"
- JOURNAL OF VACUUM SCIENCE AND TECHNOLOGY: PART B, Bd. B4, Nr. 1, Januar 1986, NEW YORK US, Seiten 73-77, XP002020451 E. CHAMBOST ET AL.: "EXPERIMENTAL RESULTS FROM FAST ELECTRON PATTERN GENERATOR: A VARIABLE SHAPED BEAM MACHINE"
- APPLIED PHYSICS LETTERS, Bd. 65, Nr. 17, 24.Oktober 1994, NEW YORK US, Seiten 2130-2132, XP000476494 H. HILLMER ET AL.: "NOVEL TUNABLE SEMICONDUCTOR LASERS USING CONTINUOUSLY CHIRPED DISTRIBUTED FEEDBACK GRATINGS WITH ULTRAHIGH SPATIAL PRECISION"
- IEEE JOURNAL OF QUANTUM ELECTRONICS, Bd. 27, Nr. 6, Juni 1991, NEW YORK US, Seiten 1767-1772, XP000229993 M. OKAI ET AL.: "CORRUGATION-PITCH MODULATED MQW-DFB LASERS WITH NARROW SPECTRAL LINEWIDTH"
- IEEE JOURNAL ON SELECTED AREAS IN COMMUNICATION, Bd. 8, Nr. 6, August 1990, NEW YORK US, Seiten 1178-1182, XP000208609 M. NAKAO ET AL.: "DISTRIBUTED FEEDBACK LASER ARRAYS FABRICATED BY SYNCHROTRON ORBITAL RADIATION LITHOGRAPHY"
- JOURNAL OF VACUUM SCIENCE AND TECHNOLOGY: PART B, Bd. 13, Nr. 6, November 1995, NEW YORK US, Seiten 2853-2858, XP000558357 H. HILLMER: "ULTRAHIGH RESOLUTION CHIRPED DISTRIBUTED FEEDBACK GRATINGS FABRICATED BY ELECTRON-BEAM LITHOGRAPHY USING BENT WAVEGUIDES FOR LOW-COST PHOTONIC COMPONENTS"

## Beschreibung

Die erfindungsgemäße Lösung wird in photonischen Bauelementen angewendet, welche auf DFB (engl. =distributed feedback) Gittern, DBR (engl. = distributed-Bragg reflector) Gittern oder axial mehrfach unterbrochenen Gitterstrukturen (engl.: "sampled grating") basieren. Das Material kann beispielsweise aus der Klasse der Halbleiter, der Gläser oder der Kunststoffe stammen. Die vorliegende Lösung ermöglicht mit hoher Ausbeute die Realisierung von optoelektronischen Bauelementen, welche Rückkopplungsgitter mit axial kontinuierlich variierbarer Korrugationsperiode aufweisen. Das verfahren ist ungeachtet der speziellen Bauformen verschiedener photonischer Bauelemente anwendbar, wenn diese auf optischen Rückkopplungsgittern basieren, und die Wellenführung der optischen Wellenleiter hinreichend groß ist. Die vorliegende Lösung erlaubt die ökonomische Herstellung von z.B. Lasern, Laser-Verstärkern, Filtern, Kopplern, Schaltern, wellenlängenkonvertern, Multiplexern, Demultiplexern und Detektoren.

Thematisch hängen folgende Arbeiten mit der vorliegenden Erfindung zusammen und sind Stand der Technik:
1) Aus der Literatur sind abrupte Änderungen der Korrugationsperiode in longitudinaler-Bauelementerichtung bekannt. In der zentral gelegenen Sektion des Laser Resonators wurde mit der Selbstinterferenz-Methode eine größere Korrugationsperiode realisiert als in den Seitensektionen z.B. wie bei M. Okai et al., IEEE J. Quantum Electron. 27, 1767 (1991). Es wurde mit dieser Struktur jedoch keine kontinuierliche Variation der Korrugationsperiode realisiert.
2) Elektronenstahl Lithographie (EL) erlaubt auch in gewissem Rahmen die Gitterperiode axial zu variieren. EL ist jedoch ein kompliziertes verfahren mit niedriger Effizienz. Ferner ist die EL Schreibzeit sehr teuer. EL erlaubt die Herstellung von DFB Gittern, welche eine kleine Anzahl verschiedener Sektionen aufweisen, innerhalb denen die Gitterperiode konstant ist, sich jedoch von Sektion zu-Sektion unterscheidet, wie z.B. von H. Ishii et al. IEEE J. Quant. Electron. 5, 613 (1993) angewendet. Es können keine kontinuierlichen Variationen der Gitterperiode mit dem Ort erreicht werden.
3) Durch gekippt verlaufende Wellenleiter auf homogenen DFB Gittern kann die Gitterperiode im wellenleiter auf einen wert eingestellt werden, der von dem des ursprünglichen DFB Gitters abweicht, wie z.B. bei H. Shoji, DE 3643361 A1, H 01 S 3/098-C (1987) sowie W. T. Tsang EP 0641053A1 und W. T. Tsang et al., IEEE Photon- Technol. Lett. PTL-5, 978 (1993).
4) Verlaufen Wellenleiter auf homogenen DFB-Gitterfeldern in gekrümmten Formen, so können Gittern mit axial variierter Gitterperiode definiert werden, wie z.B. in den folgenden Arbeiten erläutert: D. A. Ackerman et al. USS,052,015 (1.991); H. Hillmer et al. Appl. Phys. Lett. 65, 2130 (1994), H. Hillmer et al. Electron. Lett. 30, 1483 (1994), H. Hillmer DE 42 33 500. Al; .

Aufgabe der Erfindung ist es, Bauelemente, welche Gitter variabler Gitterperiode enthalten, mit einem kostengünstigen Verfahren herzustellen.

Diese Aufgabe wird gemäß einem ersten Aspekt der vorliegenden Erfindung mit einem Verfahren gemäß Anspruch 1 und gemäß einem zweiten Aspekt der vorliegenden Erfindung mit einem Verfahren gemäß Anspruch 12 gelöst.

Die erfindungsgemäßen Verfahren sollen auf möglichst ökonomischen und effizienten Technologien basieren und mit den Resourcen, wie z.B. Halbleitermaterial sparsam umgehen, so daß eine möglichst hohe Ausbeute an Bauelementen erzielt wird. Dabei handelt es sich um Bauelemente mit Wellenleitern, welche charakteristische Krümmungen, entweder erstens auf vollkommen homogenen Gitterfeldern oder zweitens auf homogenen Gitterfeldern aufweisen, welche durch quasi-abrupte Phasenverschiebungen unterbrochen sind, oder welche drittens auf periodisch unterbrochenen Gitterfeldern beruhen. Durch die wellenleiterkrümmung läßt sich eine axiale Variation der Gitterperiode einstellen, die ein gezieltes Einwirken auf bestimmte Bauelemente-Kenngrößen ermöglicht. Durch die spezielle mathemathische Form der Krümmung können bestimmte Bauelemente-Eigenschaften maßgeschneidert werden. Kernpunkt der erfindungsgemäßen Lösung ist die platzsparende Anordnung der Einzelbauelemente auf dem scheibenförmigen. Ausgangsmaterial, um die bei den herkömmlichen verfahren auftretenden Materialverluste zu minimieren. Dabei handelt es sich überwiegend um Materialverluste, welche durch den gezielten Einsatz eines lateralen wellenüberlapps oder durch die bei der Prozessierung auftretenden Randeffekte (Proximity- Effekte) entstehen.

Zwar offenbart die DE 34 26 703 A1 eine Verteilung bestimmter Merkmale auf verschiedenen Lagen eines gesamten Satzes an Photomasken auf dem Gebiet der Herstellung mikroelektronischer integrierter Schaltungen. Jedoch lassen sich die Erkenntnisse aus diesem Stand der Technik nur zum Teil in der Optoelektronik anwenden. Viele Elemente der in jenem Stand der Technik beschriebenen Lösung haben jedoch für die erfindungsgemäße Lösung keine Relevanz. Während nämlich in der Elektronik auf dem Gebiet der integrierten Speicher- und Rechnerchips und der ASICs eine Leiterbahn durchaus Knickstellen mit beliebigen Winkeln aufweisen darf bzw. in gewissem Rahmen auch Unstetigkeiten toleriert werden können, führt dies in der Optoelektronik zu ernormen Verlusten. Somit ist bereits aus diesen Gründen die Lösung gemäß jenem Stand der Technik für die Optoelektronik nicht verwendbar.

Integrierte elektronische Schaltungen werden fast ausschließlich so aufgebaut, dass keine funktionellen Einheiten über die, gewöhnlich gesägten, Chipgrenzen verlaufen. Stattdessen werden elektronische Zuleitungen meist über Kontakderungsflächen luftbrückenartig verbunden. In der Optoelektronik dagegen wird beispielsweise bei kantenemittierenden Lasern das im Wellenleiter geführte Licht an der Chipgrenze ausgekoppelt. Gerade die Ausführung dieser Grenzfläche und des Wellenleiters in ihrer Nähe ist beispielsweise für eine Lichteinkopplung in Glasfasern enorm wichtig. Die erfindungsgemäße Lösung trägt auch diesen Anforderungen Rechnung.

Die erfindungsgemäße Lösung ist auf viele Materialklassen, welche überwiegend als scheibenförmiges Ausgangsmaterial vorliegen, anwendbar. Dazu gehören beispielsweise anorganische Halbleiter, organische Halbleiter, Polymere, organische Gläser, anorganische Gläser, anorganische Dielektrika (z. B. LINbO₃), kristalline Festkörper, polykristalline Festkörper und amorphe Festkörper.

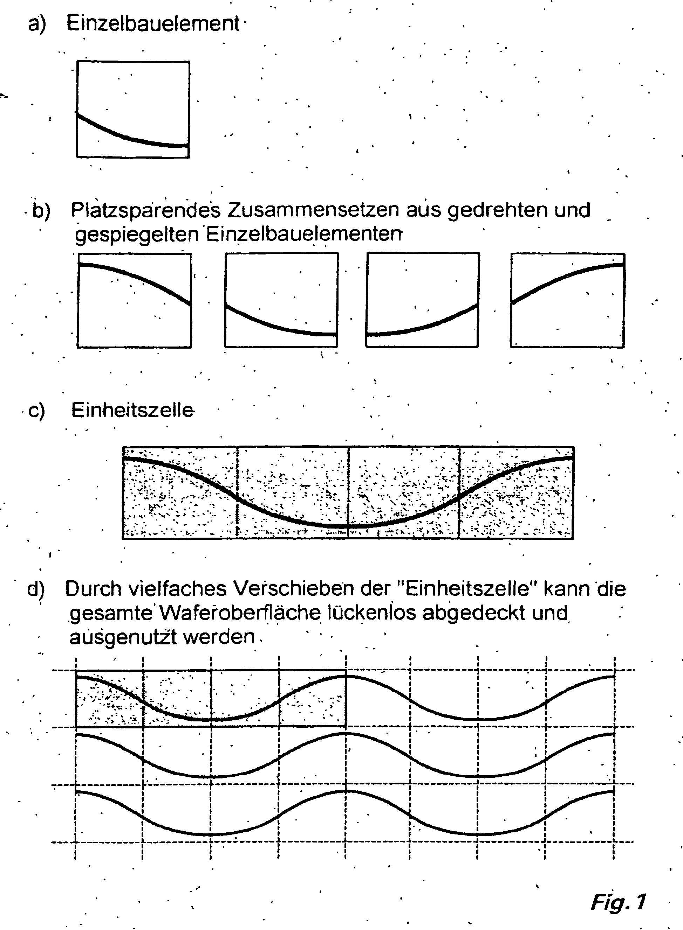

Im folgenden wird das Prinzip des erfindungsgemäßen Verfahrens jedoch an Halbleiterbauelementen erläutert. Unter dem Begriff Wafer sei entweder das reine Substratmaterial zu verstehen oder eine Heterostruktur, welche aus dem Substrat und mindestens einer anderen Materialschicht besteht. Üblicherweise sind auf dem Substrat mehrere Materialschichten mit unterschiedlichen elektronischen und optischen Eigenschaften übereinander angeordnet. Die in den Ausführungsbeispielen gezeigten Krümmungen sind zur Verdeutlichung der Effekte sehr übertrieben dargestellt, d.h. daß die Skalierung in x- und y-Richtung verschieden (die y-Achse ist sehr gedehnt dargestellt) ist. Die Form der Wellenleiterkrümmung ist direkt mit der erwünschten Variation der DFB Gitterperiode in axialer Richtung verknüpft, muß jedoch auch mit einer wichtigen Nebenbedingung in Einklang sein, welche starke Wellenleiterkrümmungen zur vermeidung von unnötig großen Krümmungsverlusten ausschließt. Das wirkprinzip des erfindungsgemäßen Verfahrens wird anhand der Herstellung eines Lithografie-Maskensatzes näher erläutert. Bei der Anwendung gekrümmter Wellenleiter in optoelektronischen Bauelementen ist der Austrittswinkel und die laterale Position des Wellenleiters an dem ersten (linken) und zweiten (rechten) Ende des Einzel-Bauelements im allgemeinen nicht identisch (Fig. 1 Abb. a). Daher kann dieses Bauelement nicht mit den üblichen verfahren hergestellt werden, ohne daß zahlreiche Bereiche des wafers ungenutzt bleiben oder daß durch das Trennen des wafers einige Bauelemente unbrauchbar werden und nach dem Prozeß als Abfall anfallen. In einem solchen Fall würde die Anzahl der intakten Bauelemente, welche pro Fläche des Ausgangsmaterials produziert werden kann, stark reduziert, was den Stückpreis für das Bauelement erhöht. Fig. 1 Abb. b hingegen zeigt die Grundprinzipien eines Verfahrens, welches es erlaubt, diese ungenutzten Flächen weitestgehend zu vermeiden:

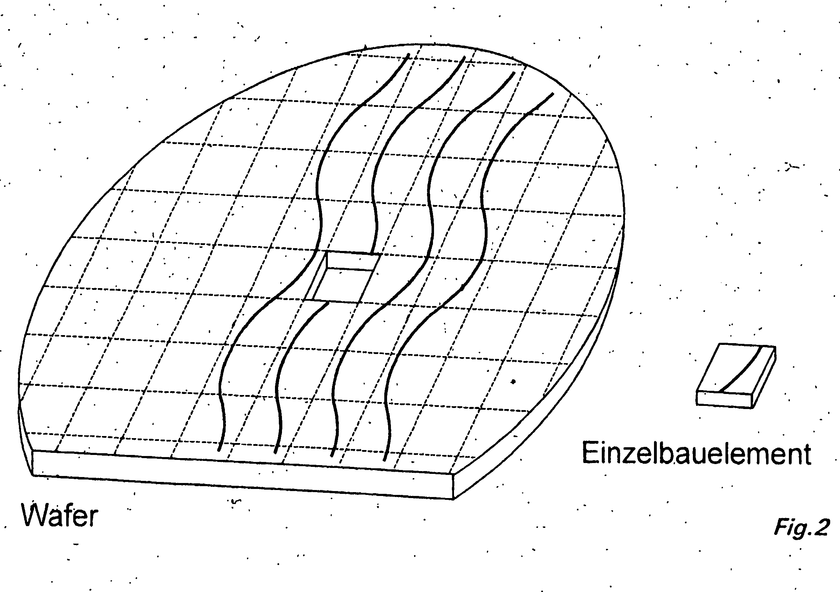

Zunächst bildet man durch mathematisches Drehen um 180° um eine Achse senkrecht zur Maskenoberfläche, sowie durch mathematisches Spiegeln der Oberflächenstruktur des Einzelbauelements an Achsen, die parallel zu den Grenzen des Einzelbauelements verlaufen, weitere geometrische Varianten von Einzelbauelement-Mustern mit nominell gleichen elektrischen und optischen Eigenschaften. Aus den so ermittelten Varianten von Einzelbauelement-Mustern wird über ein Rechenprogramm, das auf der Verschiebung der Varianten der Einzelbauelement-Muster in x- und in y-Richtung beruht, eine sogenannte Einheitszelle zusammengesetzt (Fig. 1 Abb. c). Das entscheidende Kriterium ist dabei, daß die mathematische wellenleiterkrümmungsfunktion an den Bauelementegrenzen (gestrichelte Linien) stetig und differenzierbar ist. Mit anderen Worten, die Wellenleiter benachbarter Bauelemente müssen aneinanderpassen, so daß eine über die gesamte Einheitszelle durchgehend geführte Wellenleiterstruktur entsteht. Stetigkeit und Differenzierbarkeit ist erforderich, um unnötige optische Verluste an wellenleiter-Knicken oder lateralen Wellenleiter-Versetzungen zu vermeiden. Durch ebenfalls mittels eines Rechenprogramms durchgeführtes vielfaches Verschieben und lockenloses Aneinandersetzen der ermittelten Einheitszelle , entsprechend der vom Wafer vorgegebenen Oberfläche, entsteht eine aus Einheitszellen zusammengesetzte Oberflächenstruktur, welche die Oberfläche des Wafers lückenlos abgedeckt (Fig. 1 Abb. d und Fig. 2). Wendet man das erfindungsgemäße Verfahren nacheinander auf das Design aller Masken eines Maskensatzes an, so entsteht ein geometrisch konsistenter Maskensatz für die lithografische Herstellung von optoelektronischen Bauelementen, welcher die zur Verfügung stehende Oberfläche des Wafers optimal ausnutzt.

Sollen mindestens zwei Bauelemente verschiedener Abmessungen und unterschiedlicher Wellenleiterverläufe gleichzeitig auf einem Wafer produziert werden, so wird ebenfalls entsprechend dem erfindungsgemäßen Verfahren vorgegangen. Dabei werden zweckmäßigerweise die geeignetesten Einzelbauelement-Muster ausgewählt. Die Einheitszelle kann in diesem Fall auch aus mindestens zwei verschiedenen Eintelbauelement-Mustern zusammengesetzt sein. Wenn die Stetigkeit des wellenleiters an mindestens einer Stelle unterbrochen ist, liegt die Wellenleiterversetzung jedoch noch unterhalb von 1/20 der lateralen wellenleiterbreite. Wenn die Differeinzierbarkeit des wellenleiters in mindestens einem Fall unterbrochen wird, ist der auftretende Winkelversatz jedoch kleiner als 10.
Desweiteren kann beim Reproduzieren der Einheitszelle auf der Maske die Einheitszelle in mindestens einem Fall durch Drehen um ihre Achse reproduziert werden. Vorzugsweise wird die Einheitszelle so aus Einzelbauelement-Mustern zusammengesetzt, daß die laterale Position y₁ des wellenleiters am ersten Rand der Einheitszelle gleich der lateralen Position y₂ des Wellenleiters am zweiten Rand der Einheitszelle ist. Es kann aber auch der Fall auftreten, daß die laterale Position y₁ des Wellenleiters am ersten Rand der Einheitszelle ungleich der lateralen Position y₂ des Wellenleiters am zweiten Rand der Einheitszelle ist. Wie in diesem Fall verfahren wird, ist in den folgenden Beispielen zu sehen

Das Wirkprinzip der erfindungsgemäßen Lösungen wird anhand einiger Ausführungsbeispiele näher erläutert. Dabei zeigen:
Figur 1 : Das Prinzip des Verfahrens,
Figur 2 : Die perspektivische Ansicht einer waferoberfläche. Beispiel für die platzsparende Anordung von Bauelementen mit gekrümmten Wellenleitern,
Figur 3 : Eine Einheitszelle (flächenmäßig punktiert), welche in diesem Beispiel aus 6 Einzelbauelementen besteht-Die gestrichelten Linien geben dabei die Grenzen der individuellen Bauelemente an,
Figur 4 : Eine Einheitszelle (flächenmäßig punktiert), welche in diesem Beispiel aus 3 Einzelbauelementen besteht-Die gestrichelten Linien geben dabei die Grenzen der individuellen Bauelemente an,
Figur 5 : Beispiele für Symmetrieoperationen, welche auf die in Figur 3 gezeigte Einheitszelle zur lückenlosen Flächenabdeckung des Wafers mit Bauelementen angewendet werden,
Figur 6 : Beispiele für Symmetrieoperationen, welche auf die in Figur 4 gezeigte Einheitszelle zur lückenlosen Flächenabdeckung des Wafers mit.Bauelementen angewendet werden,
Figur 7 : Ein Beispiel für den Verlauf der wellenleiterkrümmungen auf einem Waferausschnitt. B und L geben die Außenabmessungen des Einzelbauelements an,
Figur 8 : Ein Beispiel für den Verlauf der wellenleiterkrümmungen auf einem Waferausschnitt. B und L₁ geben die Außenabmessungen des ersten Einzelbauelements an-B und L₂ geben die Außenabmessungen des zweiten Einzelbauelements an,
Figur 9 : = Ein Beispiel für den Verlauf der wellenleiterkrümmungen auf einem Waferausschnitt. B und L geben die Außenabmessungen des Einzelbauelements an,
Figur 10 : Ein Beispiel für eine Einheitszelle, welche 6 Bauelemente enthält, die teilweise stufenförmig versetzt sind. Die mathemathische Wellenleiterfunktion verläuft an den Bauelementegrenzen (gestrichelte Linien) stetig und differenzierbar,
Figur 11 : Ein Beispiel für eine Einheitszelle, welche 3 Bauelemente enthält, die stufenförmig versetzt sind. Die mathemathische Wellenleiterfunktion verläuft än den Bauelementegrenzen (gestrichelte Linien) stetig und differenzierbar,
Figur 12 : Ein Beispiel für 12 Einzelbauelemente in der Einheitszelle,
Figur 13 : Ein Beispiel für 8 Einzelbauelemente in der Einheitszelle,
Figur 14 : Eine Demonstration der Stetigkeit und Differenzierbarkeit der mathematischen Krümmungsfunktion des Wellenleiters an den Grenzen der aneinandergesetzten Elementarzellen, und
Figur 15 : Ein Beispiel für eine Kombination von ungekrümmten und gekrümmten Wellenleiter-Teilabschnitten.

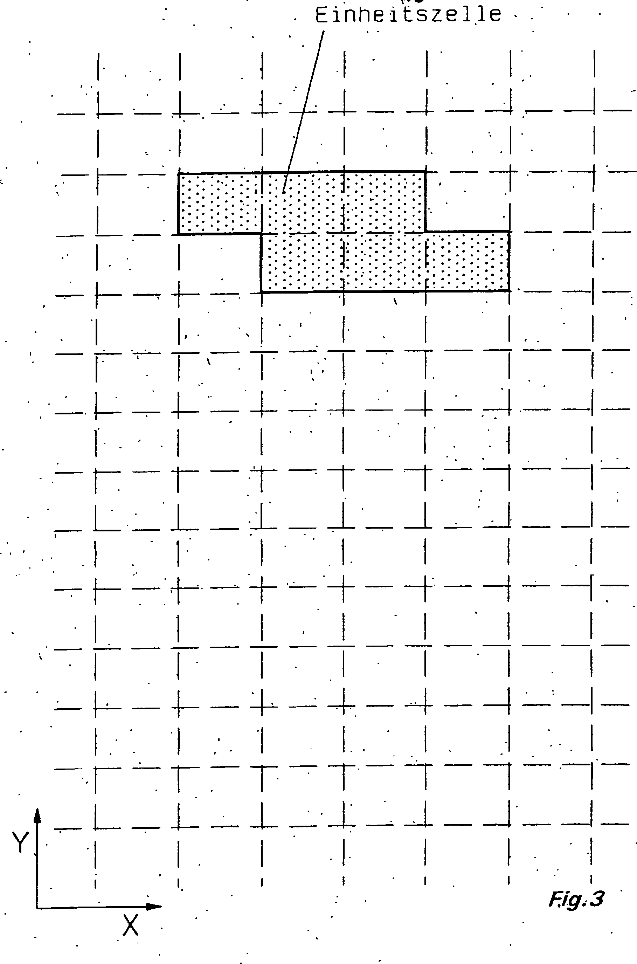

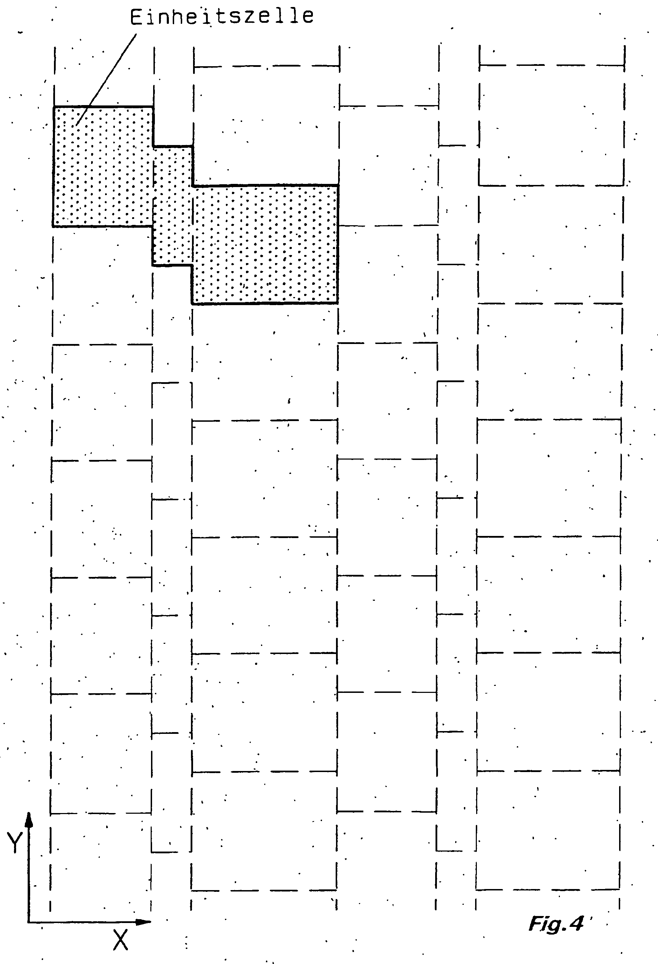

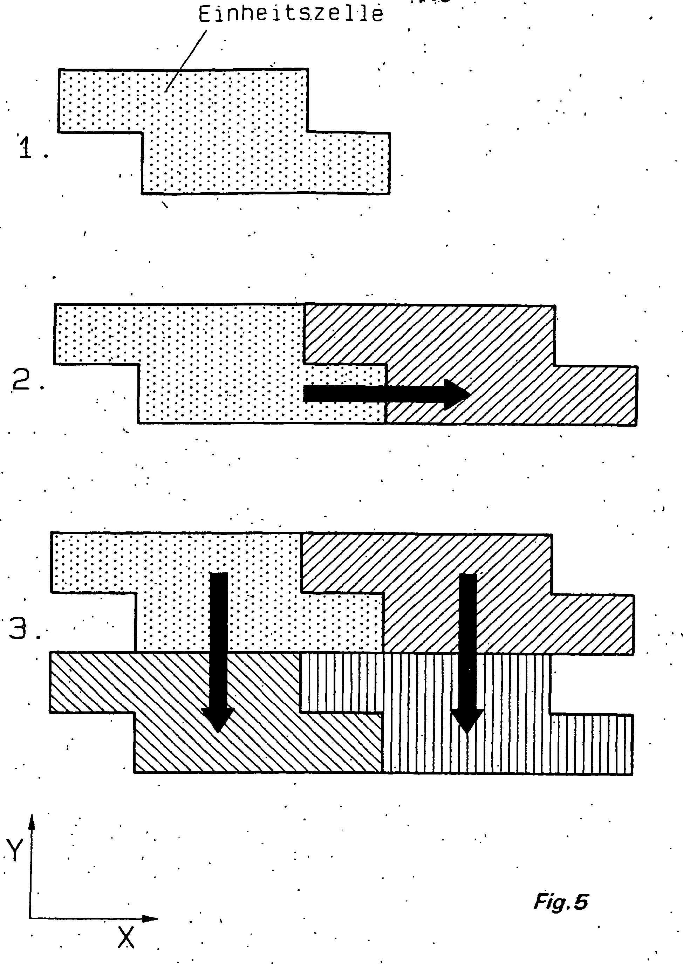

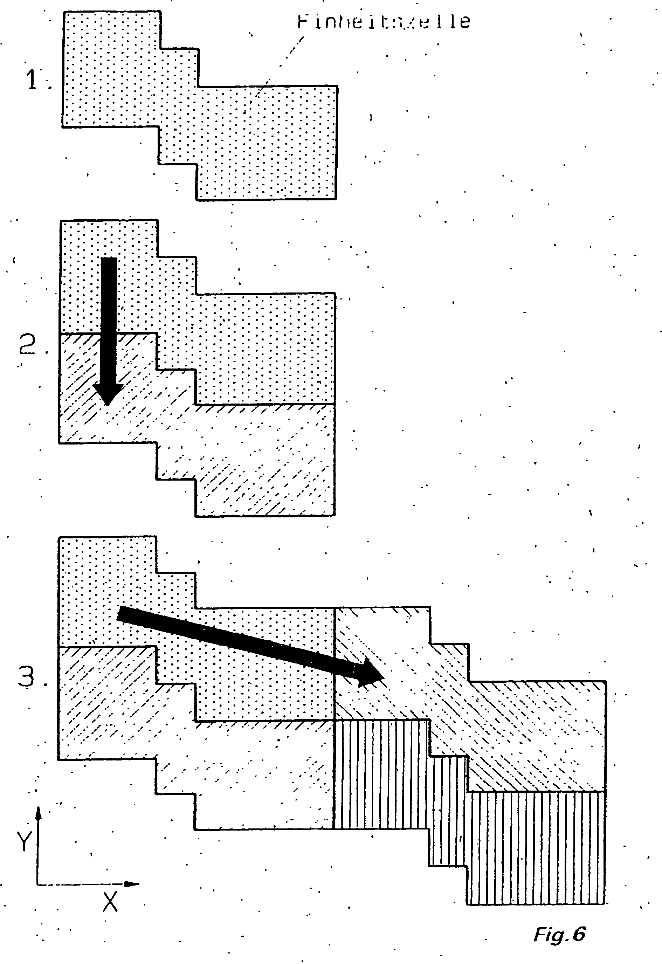

Die aufgeführten Beispiele basieren auf DFB.-Gittern, bei welchen das Gitter in longitudinaler Richtung über das gesamte Bauelement ausgedehnt ist. In den Figuren 3-6 werden Beispiele für mögliche geometrische Formen der Einheitszellen angegeben sowie die erforderlichen Verschiebungsoperationen der Einheitszelle zum lückenlosen Abdecken der Waferoberfläche demonstriert. Dabei geben die gestrichelten Linien die Bauelementegrenzen an. Entlang dieser Linien wird der Wafer nach Abschluß der Prozessierungsarbeiten gespalten oder geätzt, d. h. die Trennung der individuellen Bauelemente vorgenommen. Die waferoberfläche sei im folgenden mit der xy-Ebene identisch. Fig. 3 und 4 zeigen, daß die flächenmäßig punktiert hervorgehobene Einheitszelle verschiedenartige Formen ausbilden und mehrere Bauelemente enthalten kann. Die Einzelbauelemente weisen in Fig. 3 jeweils gleiche und in Fig. 4 jeweils verschiedene Abmessungen auf. In Bild 9 erkennt man, daß im Falle der Trennung der Einzelbauelemente durch Spalten zuerst eine Spaltung in y-Richtung und danach eine Spaltung in x-Richtung erfolgen muß. Im Falle, daß die Trennung der individuellen Bauelemente durch Ätzen erfolgt, kann diese Trennung zweckmäßigerweise in beiden Richtungen gleichzeitig erfolgen. In Fig. 5 und 6 ist korrespondierend zu den Figuren 3 und 4 das Verschieben und Aneinanderfügen der Einheitszellen für das lückenlose Ausfüllen der xy-Ebene (Waferoberfläche) gezeigt.

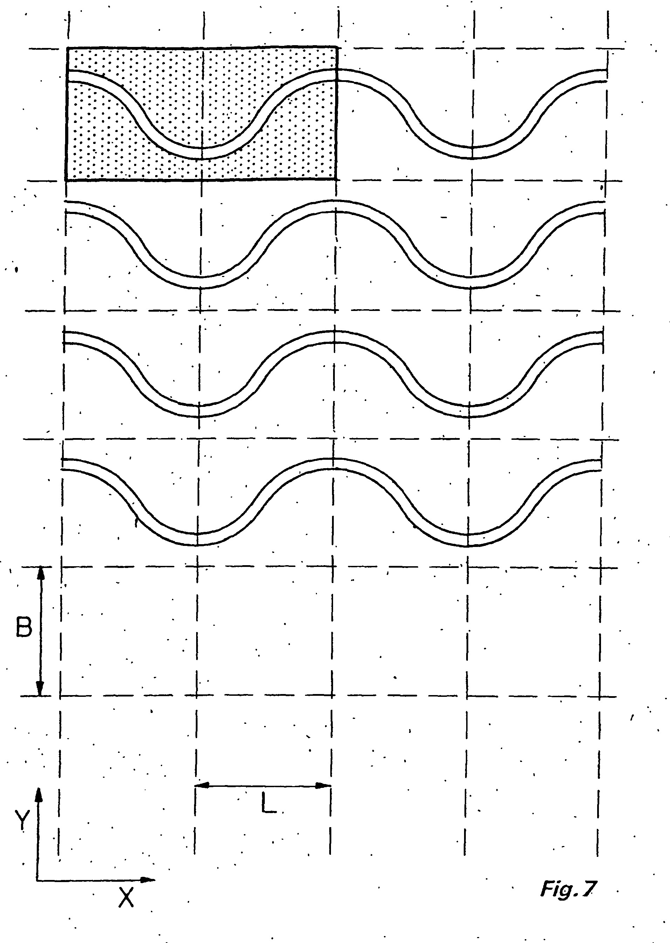

Am in Fig. 7 gezeigten Beispiel ist zu erkennen, daß die mathemathische Wellenleiterkrümmungsfunktion an den Bauelementegrenzen (gestrichelte Linien) stetig und differenzierbar verläuft. Die Einheitszelle besteht hier aus zwei physikalisch identischen Bauelementen. Verschiebungsvektoren sind z.B. (x,y) = (2L,0) oder (x,y)= (0,-B) oder (x,y) = (2L,-B).

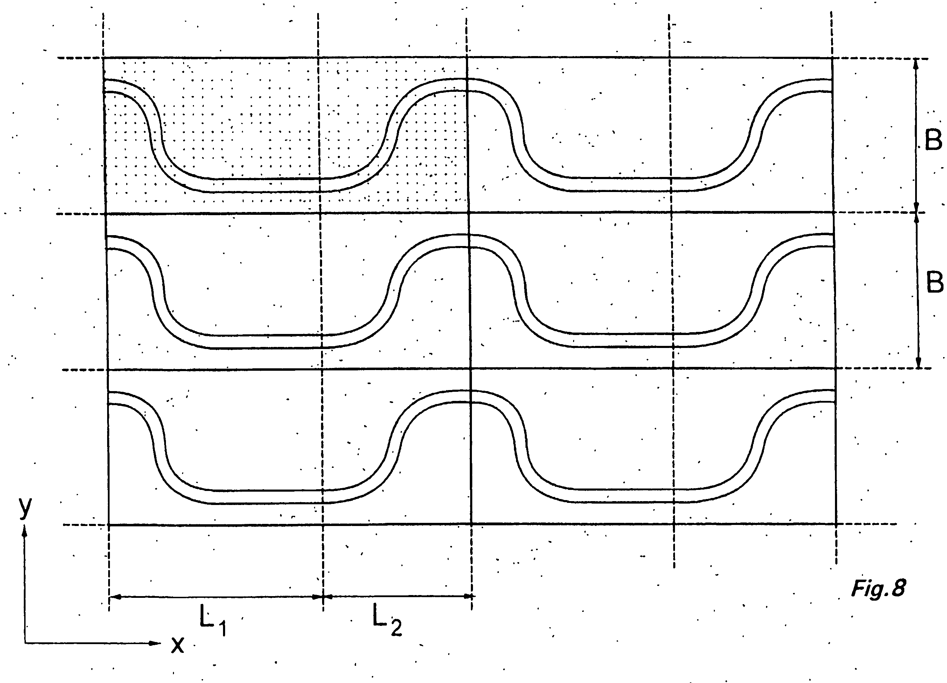

Figur 8 zeigt ein Beispiel mit zwei verschiedenen Bauelementen pro Einheitszelle. Verschiebungsvektoren sind z. B. (x,y) = (L₁ +L₂, 0) ; (x, y) = (0, -B) oder (x, y) = (L₁ +L₂, -B) . Bei den Beispielen in den Figuren 7 und 8 kann zur Trennung der Bauelemente sowohl in x- als auch in y-Richtung zuerst gespalten werden.

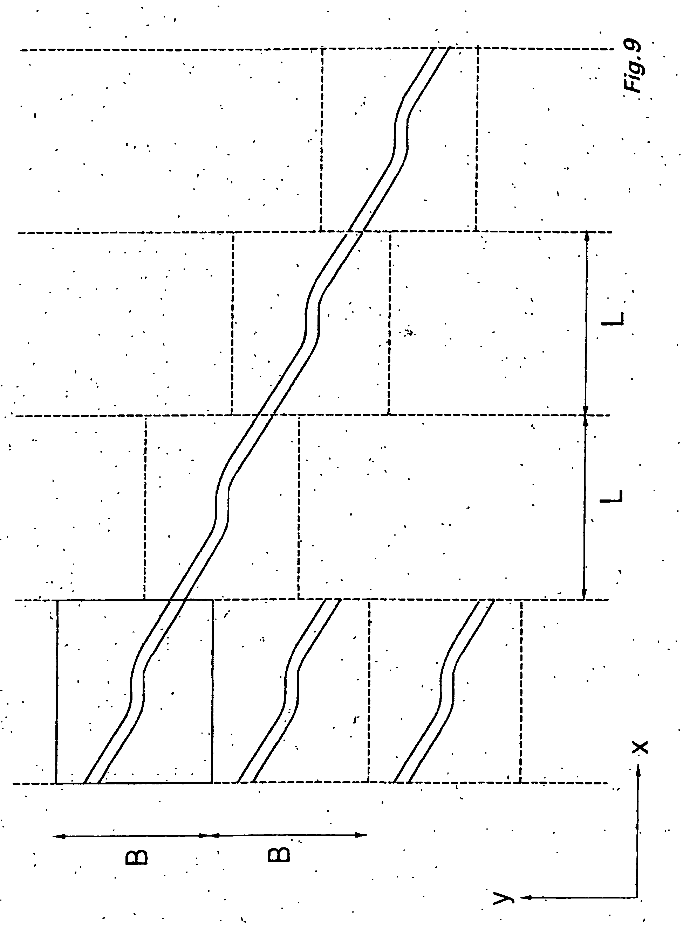

Die Figuren 9, 10 und 11 zeigen Beispiele, bei denen zur Trennung der Bauelemente zuerst in y-Richtung gespalten werden muß, da eine aus dem Wellenleiterverlauf erforderliche zusätzliche Verschiebung der Einheitszelle notwendig ist. Die mathemathische Wellenleiterkrümmungsfunktion verläuft an den Bauelementegrenzen (gestrichelte Linien) stetig und differenzierbar.

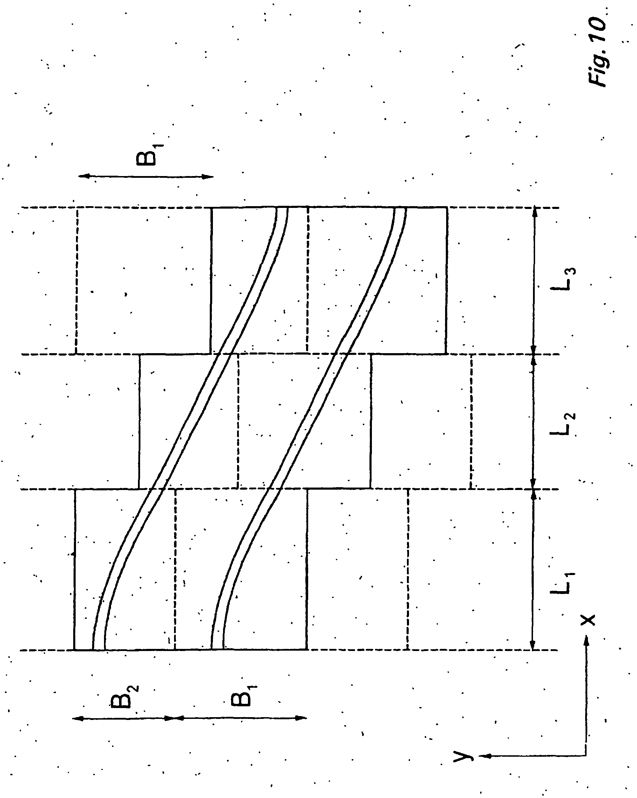

In Fig. 10 besteht die Einheitszelle aus 6 physikalisch verschiedenen Bauelementen. Verschiebungsvektoren sind z.B. (x,y) = (L₁ +L₂ +L₃ ,-a) oder (x,y) - (0,-B₁ -B₂), wobei a der Versatz des Wellenleiters in y-Richtung zwischen der linken und rechten Einheitszellen-Grenze ist (a = y₁ -y₂ ).

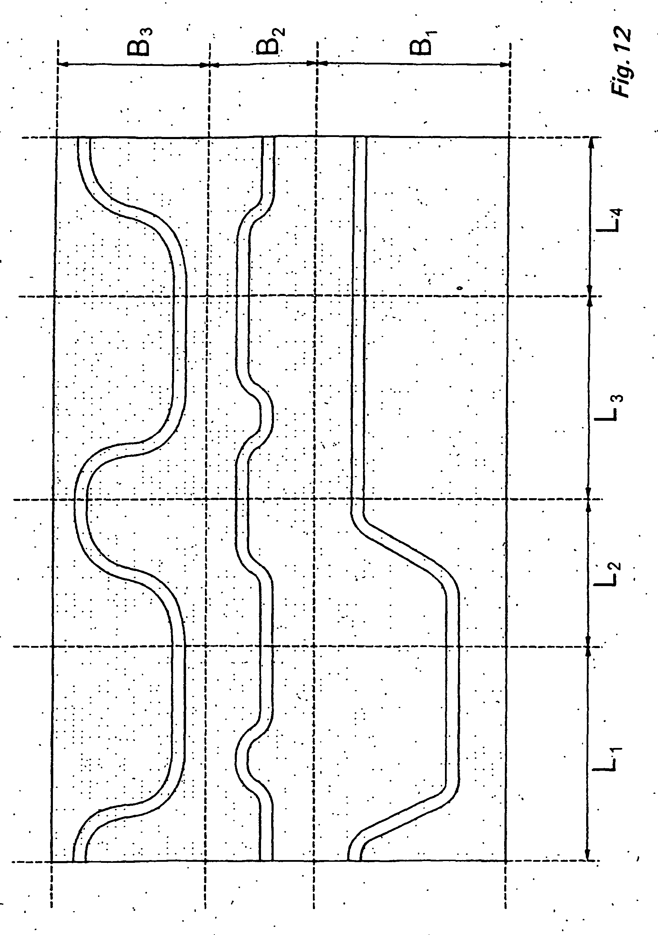

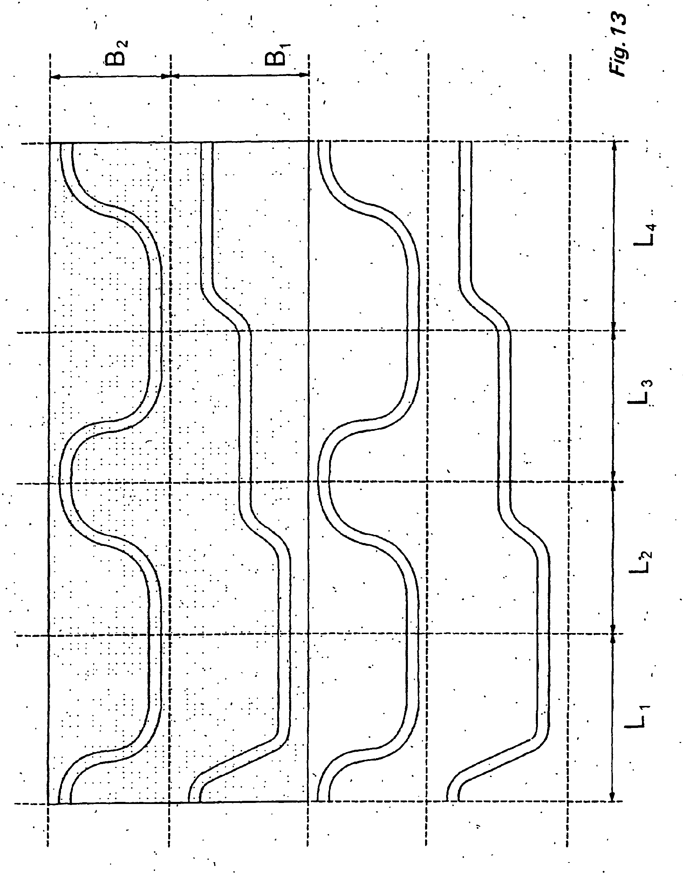

Die Figuren 12 und 13 zeigen, daß viele und sehr unterschiedliche Bauelemente in einer Einheitszelle vereint werden können. In Fig. 12 sind auch Bauelemente mit geradem Verlauf der Wellenleiter enthalten. In Fig. 13 sind mögliche verschiebungsvektoren z-B. (x,y) =(L₁) +L₂ +L₃ +L₄,0) oder (x,y) = (0,-B₁ -B₂) oder (L₁ + L₂ +L₃ +L₄, -B₁ - B₂).

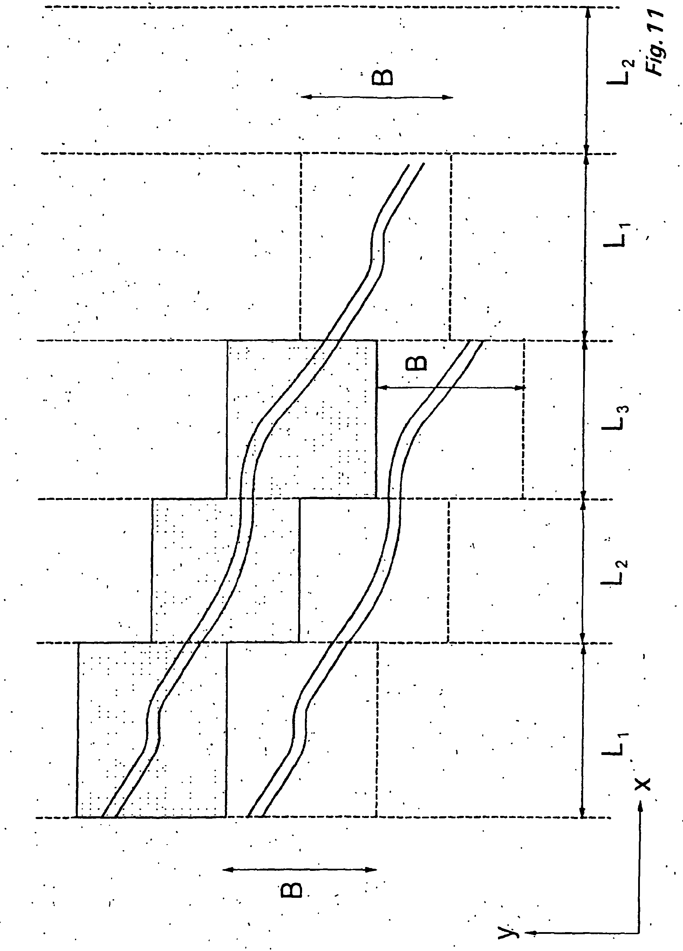

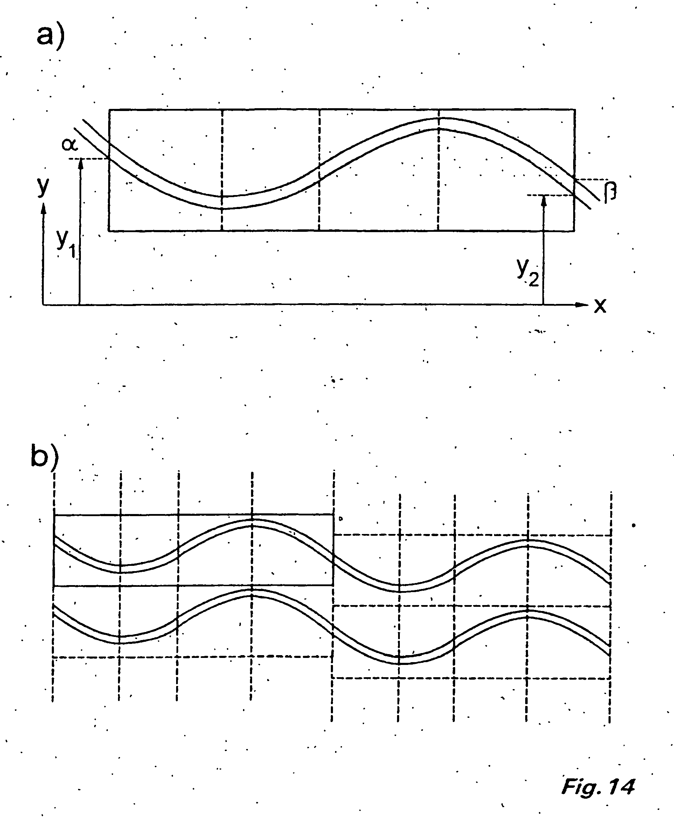

Figur 14 verdeutlicht an einem Beispiel, daß der Wellenleiter am linken und am rechten Rand der Einheitszelle die Begrenzungslinie jeweils unter demselben Winkel schneiden sollte. Hier bedeutet das die Gleichheit der Winkel α und β. Die Positionen der Wellenleiter in y-Richtung müssen nicht übereinstimmen, d. h. y₁ kann von y₂ verschieden sein. Je größer der Unterschied zwischen y₁ und y₂ ist, um so größer ist der in Fig. 11 b dargestellte stufenförmige Versatz in y-Richtung nach dem Anwenden der Symmetrieoperationen Der stufenförmige Versatz berechnet sich hier aus a = y₁ - y₂.

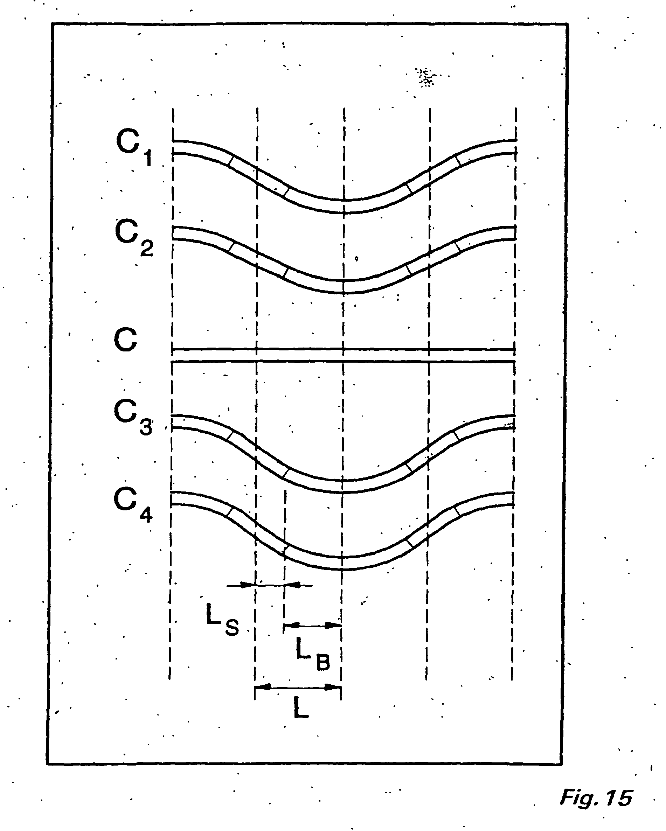

Figur 15 zeigt Bauelemente mit vollständig geraden wellenleitern (C) sowie Bauelemenete mit Wellenleitern, welche sowohl gekrümmte der Länge L_{B} , als auch gerade Teilstücke der Länge L_{S} aufweisen (C₁, C₂, C₃ und C₄); wobei L_{S} +L_{B} =L ist. Bei den Wellenleitern C₁, C₂, C₃ und C₄ erkennt man die angewendeten mathematischen Symmetrieoperationen (Spiegeln und Drehen des Ursprungs-Einzelbauelements)

Das erfindungsgemäße Verfahren wurde zwar anhand der Herstellung eines Lithografie-Maskensatzes näher erläutert, es läßt sich jedoch auch für die Strukturierung von optoelektronischen Bauelementen mittels Elektronenstrahl-Lithografie bzw. Ionenstrahl-Lithografie verwenden- Bei diesen Verfahren werden die Strukturen für die optoelektronischen Bauelemente direkt in einer auf dem Wafer aufgetragenen Lackschicht erzeugt.

## Patentansprüche

1. verfahren zur Herstellung optoelektronischer Bauelemente unter Benutzung geläufiger Strukturierungsverfahren, wobei auf einem scheibenförmigen Ausgangsmaterial in der Fläche nebeneinander eine Vielzahl optoelektronischer Bauelemente simultan hergestellt wird, unter Verwendung eines Lithographie-Maskensatzes zur Abarbeitung der einzelnen Herstellungsschritte, wobei jede Maske planare geometrische Muster aufweist, **dadurch gekennzeichnet, daß** für jede Maske aus den planaren geometrischen Mustern, die innerhalb der Grenzen eines Einzelbauelements liegen, durch mathematisches Drehen um 180° um eine Achse senkrecht zur Maskenoberfläche, sowie durch Spiegeln an Achsen, welche parallel zu den Grenzen des Einzelbauelements verlaufen, alle möglichen geometrischen Varianten von Einzelbauelement-Mustern ermittelt werden, wobei die elektrischen und die optischen Eigenschaften der am Ende resultierenden Einzelbauelemente nominell gleich sind, daß aus den erhaltenen geometrischen Varianten von Einzelbauelement-Mustern durch Verschieben der Varianten der Einzelbauelement-Muster in x- und y-Richtung eine Einheitszelle gebildet wird, in der die verwendeten Einzelbauelement-Muster unter Gewährleistung einer durchgehenden Wellenleiterstruktur paßgenau aneinandergefügt sind, so daß die Stetigkeit und Differenzierbarkeit der gesamten mathematischen Hellenleiterkrümmungsfunktionen garantiert ist, wobei der Eintrittswinkel(α) des Wellenleiters an einem ersten Rand der Einheitszelle mit dem Austrittswintkel (β) des Wellenleiters an einem dem esten Rand gegenübeliegenden zweiten Rand der Einheitszelle übereinstimmt, daß die Einheitszelle in x- und in y-Richtung reproduziert wird, bis die aktive Fläche der Maske lückenlos abgedeckt ist, wobei zweckmäßigerweise die aktive Flache der Maske das scheibenförmige Ausgangsmaterial in allen Richtungen überragt, und daß die o.g. schritte nacheinander auf das Design aller anderen Masken angewendet werden, so daß sich ein in sich geometrisch konsistenter Maskensatz für die lithografische Bauelemente-Herstellung ergibt.

2. Verfahren nach Anspruch 1. **dadurch gekennzeichnet, daß** von den konstruierten möglichen Varianten von Einzelbauelement-Mustern rechentechnisch die für die Konstruktion der Einheitszelle am besten geeigneten Einzelbauelement-Muster ermittelt und für die Einheitszelle verwendet werden, wobei rechentechnisch die Gleichheit der Winkel (α und β), sowie die mathematische Stetigkeit und Differenzierbarkeit der Nellenleiterkrummungsfunktionen in der Einheitszelle sichergestellt werden.

3. Verfahren nach Anspruch 1, **dadurch gekennzeichnet, daß** mindestens zwei völlig verschiedene Einzelbauelement-Muster zu einer Einheitszelle zusammengefügt werden, so daß nach der Prozessierung mindestens zwei verschiedene Bauelemente entstehen.

4. verfahren nach Anspruch 3, **dadurch gekennzeichnet, daß** in der Einheitszelle die Position für mindestens ein Einzelbauelement-Muster freigelassen wird.

5. Verfahren nach Anspruch 3, **dadurch gekennzeichnet, daß** an mindestens einer Stelle auf der Maske an der Position mindestens einer Einheitszelle eine molifizierte Belegung mit Bauelementen vorgenommen wird, wobei mindestens eine Bauelemente-Position freigelassen wird.

6. Verfahren nach Anspruch 1, **dadurch gekennzeichnet, daß** die Stetigkeit des wellenleiters in mindestens einem Fall unterbrochen wird, die laterale Wellenleiterversetzung jedoch unterhalb von 1/20 der lateralen Wellenleiterbreite liegt.

7. verfahren nach Anspruch 1, **dadurch gekennzeichnet, daß** die Differenzierbarkeit des Wellenleiters in mindestens einem Fall unterbrochen wird, der auftretende Winkelversatz jedoch kleiner als 1° ist.

8. Verfahren nach Anspruch 1, **dadurch gekennzeichnet, daß** beim Reproduzieren der Einheitszelle auf der Maske die Flache für mindestens eine Einheitszelle frei bleibt.

9. Verfahren nach Anspruch 1, **dadurch gekennzeichnet, daß** beim Reproduzieren der Einheitszelle auf der Maske die Einheitszelle in mindestens einem Fall durch Drehen um eine ihrer Achsen reproduziert wird.

10. Verfahren nach Anspruch 1, **dadurch gekennzeichnet, daß** die laterale Position (y₁) des Wellenleiters am ersten Rand der Einheitszelle gleich der lateralen Position (y₂) des wellenleiters am zweiten Rand der Einheitszelle ist.

11. verfahren nach Anspruch 1, **dadurch gekennzeichnet, daß** die laterale Position (y₁) des Wellenleiters am ersten Rand der Einheitszelle ungleich der lateralen Position (y₂)des Wellenleiters am zweiten Rand der Einheitszelle ist.

12. Verfahren zur Herstellung von Strukturen für optoelektronische Bauelemente, welche mittels Elektronenstrahl Lithografie bzw. lonenstrahl-Lithografie in einem scheibenförmigen Ausgangsmaterial direkt in einer aufgetragenen Lackschicht erzeugt werden, unter Benutzung geläufiger Strukturierungsverfahren,
**dadurch gekennzeichnet, dass** aus planaren geometrischen Mustern, die innerhalb der Grenzen eines Einzelbauelementes liegen, durch mathematisches Drehen um 180° um eine Achse senkrecht zur Oberfläche des Einzelbauelementes sowie durch Spiegeln an Achsen, welche parallel zu den Grenzen des Einzelbauelementes verlaufen, alle möglichen geometrischen Varianten von Einzelbauelement-Mustern ermittelt werden, wobei die elektrischen und die optischen Eigenschaften der am Ende resultierenden Einzelbauelemente nominell gleich sind, dass aus den erhaltenen geometrischen Varianten von Einzelbauelement-Mustern durch Verschieben der Varianten der Einzelbauelement-Muster in x- und y-Richtung eine Einheitszelle gebildet wird in der die verwendeten Einzelbauelement-Muster unter Gewährleistung einer durchgehenden Wellenleiterstruktur passgenau aneinandergefügt sind, so dass die Stetigkeit und Differenzierbarkeit der gesamten mathematischen Wellenteiterkrümmungsfunktionen garantiert ist, wobei der Eintrittswinkei (α) des Wellenleiters an einem ersten Rand der Einheitszelle mit dem Austrittswinkel (β) des Wellenleiters an einem dem ersten Rand gegenüberliegenden zweiten Rand der Einheitszelle übereinstimmt, und dass die Einheitszelle in x- und y-Richtung reproduziert wird, bis die aktive Fläche des scheibenförmigen Ausgangsmaterials lückenlos abgedeckt ist.

## Claims

1. Method for producing optoelectronic components by common structuring methods, wherein a large number of optoelectronic components is simultaneously produced adjacently over the surface of a sheet-form starting material, using a set of lithographic masks for carrying out the individual steps of the method, each mask exhibiting planar geometric patterns, **characterised in that** all possible geometric variants of individual component patterns are determined for each mask from the planar geometric patterns which lie within the limits of an individual component, by a mathematical 180° rotation about an axis perpendicular to the mask surface, and by reflection at axes which extend parallel to the limits of the individual component, the electric and optical characteristics of the individual components resulting at the end of the process being nominally identical, **in that** a unit cell is formed from the resulting geometric variants of individual component patterns by shifting the variants of the individual component patterns in the x and y direction, in which unit cell the individual component patterns used are joined together in a precisely fitting manner, while ensuring a continuous waveguide structure, so that the continuity and differentiability of the complete mathematical waveguide curvature functions is guaranteed, the angle of incidence (α) of the waveguide on a first edge of the unit cell coinciding with the angle of emergence (β) of the waveguide at a second edge opposite the first edge, of the unit cell, **in that** the unit cell is reproduced in the x and y direction until the active surface of the mask is completely covered, the active surface of the mask advantageously projecting over the sheet-form starting material in all directions, and **in that** the above-mentioned steps are applied in succession to the design of all other masks, so that a set of masks which is geometrically consistent *per se* is produced for the production of lithographic components.

2. Method according to claim 1, **characterised in that** the individual component patterns which are best suited to the construction of the unit cell are determined by computation from the conceived possible variants of individual component patterns and are used for the unit cell, the equality of the angles (α and β), and the mathematical continuity and differentiability of the waveguide curvature functions in the unit cell being ensured by computation.

3. Method according to claim 1, **characterised in that** at least two completely different individual component patterns are joined together to form a unit cell so that, after processing, at least two different components are produced.

4. Method according to claim 3, **characterised in that** the position for at least one individual component pattern is left open in the unit cell.

5. Method according to claim 3, **characterised in that** a modified occupancy with components is carried out in at least one location on the mask in the position of at least one unit cell, at least one component position being left open.

6. Method according to claim 1, **characterised in that** the continuity of the waveguide is interrupted in at least one case, the lateral waveguide offset still being less than 1/20 of the lateral waveguide width.

7. Method according to claim 1, **characterised in that** the differentiability of the waveguide is interrupted in at least one case, the resulting angular offset still being less than 1°.

8. Method according to claim 1, **characterised in that** when the unit cell is reproduced on the mask, the surface is left open for at least one unit cell.

9. Method according to claim 1, **characterised in that** when the unit cell is reproduced on the mask, the unit cell is reproduced in at least one case by rotation about one of the axes of said cell.

10. Method according to claim 1, **characterised in that** the lateral position (y₁) of the waveguide on the first edge of the unit cell is identical to the lateral position (y₂) of the waveguide on the second edge of the unit cell.

11. Method according to claim 1, **characterised in that** the lateral position (y₁) of the waveguide on the first edge of the unit cell is not equal to the lateral position (y₂) of the waveguide on the second edge of the unit cell.

12. Method for producing structures for optoelectronic components which are directly produced in an applied lacquer coat by electron or ion beam lithography in a sheet-form starting material, by common structuring methods, **characterised in that** all possible geometric variants of individual component patterns are determined from planar geometric patterns which lie within the limits of an individual component, by a mathematical 180° rotation about an axis perpendicular to the surface of the individual component and by reflection at axes which extend parallel to the limits of the individual component, the electric and optical characteristics of the individual components resulting at the end of the process being nominally identical, **in that** a unit cell is formed from the resulting geometric variants of individual component patterns by shifting the variants of the individual component patterns in the x and y direction, in which unit cell the individual component patterns used are joined together in a precisely fitting manner, while ensuring a continuous waveguide structure so that the continuity and differentiability of the complete mathematical waveguide curvature functions is guaranteed, the angle of incidence (α) of the waveguide on a first edge of the unit cell coinciding with the angle of emergence (β) of the waveguide at a second edge opposite the first edge, of the unit cell, and **in that** the unit cell is reproduced in the x and y direction until the active surface of the sheet-form starting material is completely covered.

## Revendications

1. Procédé pour la fabrication de composants optoélectroniques en utilisant des procédés de structuration courants, une pluralité de composants optoélectroniques étant réalisés simultanément les uns à côté des autres en surface sur un matériau de départ en forme de disque en utilisant un jeu de masques de lithographie pour l'exécution des différentes étapes de fabrication, chaque masque comprenant des modèles géométriques planes,
**caractérisé en ce que** pour chaque masque comprenant des modèles géométriques planes situés à l'intérieur des limites d'un composant individuel sont déterminées, par une rotation mathématique de 180° autour d'un axe perpendiculaire à la surface du masque ainsi que par une réflexion sur des axes s'étendant parallèlement aux limites du composant individuel, toutes les variantes géométriques possibles de modèles de composants individuels, les propriétés électriques et optiques des composants individuels obtenus à la fin étant nominalement égaux, **en ce qu'**à partir des variantes géométriques de modèles de composants individuels obtenues est formée, par un déplacement dans la direction x et dans la direction y des variantes des modèles de composants individuels, une cellule unitaire dans laquelle les modèles de composants individuels utilisés sont accolés avec un ajustement précis les uns aux autres tout en garantissant une structure de guide d'ondes continue, de sorte que la continuité et la possibilité de différenciation de l'ensemble des fonctions mathématiques de courbure des guides d'ondes sont garanties, l'angle d'entrée (α) du guide d'ondes étant, sur un premier bord de la cellule unitaire, en concordance avec l'angle de sortie (β) du guide d'ondes sur un deuxième bord de la cellule unitaire qui est opposé au premier bord, **en ce que** la cellule unitaire est reproduite dans la direction x et dans la direction y jusqu'à ce que la surface active du masque soit recouverte sans interruption, la surface active du masque dépassant utilement dans toutes les directions le matériau de départ en forme de disque et **en ce que** les étapes susmentionnées sont mises en oeuvre successivement pour le dessin de tous les autres masques, de sorte qu'il en résulte pour la fabrication lithographique des composants un jeu de masques géométriquement consistant en soi.

2. Procédé selon la revendication 1, **caractérisé en ce que**, parmi les variantes possibles construites de modèles de composants individuels, les modèles de composants individuels les mieux appropriés pour la construction de la cellule unitaire sont déterminés par le calcul et sont utilisés pour la cellule unitaire, l'égalité des angles (α et β) ainsi que la continuité et la possibilité de différenciation des fonctions de courbure des guides d'ondes mathématiques dans la cellule unitaire étant garanties par le calcul.

3. Procédé selon la revendication 1, **caractérisé en ce qu'**au moins deux modèles de composants individuels entièrement différents sont rassemblés pour former une cellule unitaire, de sorte qu'au moins deux composants différents soient obtenus après l'exécution du procédé.

4. Procédé selon la revendication 3, **caractérisé en ce que**, dans la cellule unitaire, la position pour au moins un modèle de composant individuel est laissée libre.

5. Procédé selon la revendication 3, **caractérisé en ce qu'**à au moins un endroit sur le masque et à la position d'au moins une cellule unitaire a lieu une occupation par des composants qui est modifiée, au moins une position de composant étant laissée libre.

6. Procédé selon la revendication 1, **caractérisé en ce que** la continuité du guide d'ondes est interrompue dans au moins un cas, le décalage latéral du guide d'ondes étant cependant inférieur à 1/20 de la largeur latérale du guide d'ondes.

7. Procédé selon la revendication 1, **caractérisé en ce que** la possibilité de différenciation du guide d'ondes est interrompue dans au moins un cas, le décalage angulaire qui se produit étant toutefois inférieur à 1°.

8. Procédé selon la revendication 1, **caractérisé en ce que**, lors de la reproduction de la cellule unitaire sur le masque, la surface pour au moins une cellule unitaire reste libre.

9. Procédé selon la revendication 1, **caractérisé en ce que**, lors de la reproduction de la cellule unitaire sur le masque, la cellule unitaire est reproduite dans au moins un cas par une rotation autour d'un de ses axes.

10. Procédé selon la revendication 1, **caractérisé en ce que** la position latérale (y1) du guide d'ondes sur le premier bord de la cellule unitaire est la même que la position latérale (y2) du guide d'ondes sur le deuxième bord de la cellule unitaire.

11. Procédé selon la revendication 1, **caractérisé en ce que** la position latérale (y1) du guide d'ondes sur le premier bord de la cellule unitaire n'est pas la même que la position latérale (y2) du guide d'ondes sur le deuxième bord de la cellule unitaire.

12. Procédé pour la fabrication de structures pour des composants optoélectroniques, lesquelles sont, au moyen de lithographie par rayons d'électrons ou de lithographie par rayons d'ions et en utilisant des procédés de structuration courants, produites dans un matériau de départ en forme de disque directement dans une couche de vernis appliquée,
**caractérisé en ce qu'**à partir de modèles géométriques planes situés à l'intérieur des limites d'un composant individuel sont déterminées, par une rotation mathématique de 180° autour d'un axe perpendiculaire à la surface du composant individuel ainsi que par une réflexion sur des axes s'étendant parallèlement aux limites du composant individuel, toutes les variantes géométriques possibles de modèles de composants individuels, les propriétés électriques et optiques des composants individuels obtenus à la fin étant nominalement égaux, **en ce qu'**à partir des variantes géométriques de modèles de composants individuels obtenues est formée, par un déplacement dans la direction x et dans la direction y des variantes des modèles de composants individuels, une cellule unitaire dans laquelle les modèles de composants individuels utilisés sont accolés avec un ajustement précis les uns aux autres tout en garantissant une structure de guide d'ondes continue, de sorte que la continuité et la possibilité de différenciation de l'ensemble des fonctions mathématiques de courbure des guides d'ondes sont garanties, l'angle d'entrée (α) du guide d'ondes étant sur un premier bord de la cellule unitaire en concordance avec l'angle de sortie (β) du guide d'ondes sur un deuxième bord de la cellule unitaire qui est opposé au premier bord, et **en ce que** la cellule unitaire est reproduite dans la direction x et dans la direction y jusqu'à ce que la surface active du matériau de départ en forme de disque soit recouverte sans interruption.
